# EUROPEAN PATENT APPLICATION

(11) **EP 4 407 078 A1**
(43) Date of publication of application: **31.07.2024**
(21) Application number: 23864160.9
(22) Date of filing: 24.11.2023
(51) Int. Cl.: C30B 33/02

(54) **COMPOSITE SUBSTRATE PREPARATION METHOD**

(30) Priority: 12.12.2022 CN 202211587497
(71) Applicant: TJ Innovative Semiconductor Substrate Technology Co., Ltd., Tianjin 300451 (CN)
(72) Inventor: MU, Fengwen, Tianjin 300451 (CN); GUO, Chao, Tianjin 300451 (CN); TAO, Xianghu, Tianjin 300451 (CN)
(74) Representative: Meroni, Francesca
(86) International application number: PCT/CN2023/133943
(87) International publication number: WO 2024/125264

(57) **Abstract**

Provided is a preparation method for a composite substrate. The preparation method comprises the following steps: (1) growing a crystal layer on one surface of a single-crystal substrate which is used as a seed crystal to obtain a composite crystal layer structure consisting of the single-crystal substrate and the crystal layer; and (2) subjecting the composite crystal layer structure to laser irradiation to form a modified layer inside the single-crystal substrate of the composite crystal layer structure; dividing the single-crystal substrate along the modified layer by applying an external force to obtain a composite substrate. In the preparation method of the present application, by growing a low-quality crystal layer on a high-quality single-crystal substrate and then using a laser cold-cracking cutting process, the composite substrate has high preparation efficiency, good quality, and wide application range.

## Description

### TECHNICAL FIELD

The present application relates to the field of semiconductor technology, for example, a preparation method for a composite substrate.

### BACKGROUND

Devices made of silicon carbide single-crystal substrate have the advantages of high-temperature resistance, high-voltage resistance, high frequency, high power, radiation resistance, and high efficiency, and have important application value in radio frequency, new energy vehicles, and other fields.

A conventional preparation method for the silicon carbide single-crystal substrate includes the following process: silicon carbide single crystal is grown by physical vapor transport method to obtain a silicon carbide single-crystal ingot; the periphery of the crystal ingot is processed to obtain the desired diameter and surface quality, and then the crystal ingot is cut into thin slices, and the thin slices are ground and polished to obtain the desired thickness and flatness, so as to obtain the final silicon carbide single-crystal substrate. The growth of silicon carbide single crystals based on the physical vapor transport method is inefficient, and as a result, the cost of a single silicon carbide single-crystal substrate is very high.

One solution to reduce the cost of silicon carbide substrates is to use a composite substrate structure: a thin layer of silicon carbide single crystal is bonded to a cheap supporting substrate. This solution requires individually processing the surfaces of the low-quality and high-quality substrates to make the surface quality meet the bonding requirements, and then the two substrates are bonded. The high-quality surface machining has some complexity and difficulty. In addition, this solution leads to a bonding interface layer, which may negatively affect the vertical conductivity of the substrate.

CN114746980A discloses a method for manufacturing a composite substrate: forming a pre-buried weakened layer in a high-quality single-crystal substrate by ion implantation; depositing a low-quality crystalline layer or a polycrystalline layer on the surface of the single-crystal substrate by the CVD method; and performing detachment along the weakened layer so as to obtain a composite substrate. The problem of this method is that due to the high temperature required by the CVD process, the pre-buried weakened layer may crack early during the CVD process, interrupting the CVD process.

CN112701033A discloses a preparation method for a composite substrate, a composite substrate, and a composite film, wherein the preparation method for a composite substrate comprises: cleaning a single-crystal silicon substrate, so as to obtain a single-crystal silicon substrate layer with a clean surface; growing polycrystalline silicon on the clean surface of the single-crystal silicon substrate layer, and performing a flattening process to form a first polycrystalline silicon layer; performing laser focusing on a surface of the first polycrystalline silicon layer near the single-crystal silicon substrate layer until a single-crystal silicon fusion layer is formed, and stopping the laser focusing, so as to obtain the composite substrate; the composite substrate comprises the single-crystal silicon substrate layer, the single-crystal silicon fusion layer, and a second polycrystalline silicon layer in sequence from bottom to top. For the aforementioned solution, the position, distribution, and size of the single-crystal silicon fusion region are accurately controlled by adjusting the power, the focal length, and the position of the laser, so that the bonding force of the target region at the target interface can be improved according to the actual conditions of the single-crystal silicon substrate layer and the polycrystalline silicon layer, and the adhesion of the polycrystalline silicon deposited on the silicon substrate can be improved. However, the preparation efficiency of the above preparation method is low.

Therefore, it is of great significance to develop a new preparation method for composite substrates to improve the manufacturing efficiency and quality of the composite substrate.

### SUMMARY

The following is a summary of the subject matter described in detail herein. This summary is not intended to limit the scope of the claims.

In view of the problems existing in the prior art, the present application provides a preparation method for a composite substrate. By growing a low-quality crystal layer on a high-quality single-crystal substrate, the manufacturing efficiency of the composite substrate is improved. Moreover, by a laser cold-cracking cutting process, a composite substrate having a thin high-quality single-crystal substrate is obtained, and the composite substrate is of high quality and has a wide application range.

The present application provides a preparation method for a composite substrate, and the preparation method comprises the following steps:
(1) growing a crystal layer on one surface of a single-crystal substrate which is used as a seed crystal to obtain a composite crystal layer structure consisting of the single-crystal substrate and the crystal layer; and
(2) subjecting the composite crystal layer structure to laser irradiation to form a modified layer inside the single-crystal substrate of the composite crystal layer structure; dividing the single-crystal substrate along the modified layer by applying an external force to obtain a composite substrate.

The single-crystal substrate in the preparation method of a composite substrate provided by the present application is a high-quality single-crystal substrate in which there are few defects such as micropipes, dislocations, phase transformations, and polycrystal inclusions. Such high-quality single-crystal substrate serves as a growth basis for a low-quality crystal layer and grows the low-quality crystal layer on its Si-face or C-face. The low-quality crystal layer is allowed to contain more defects such as micropipes, dislocations, phase transformations, and polycrystal inclusions, and the low-quality crystal layer can be a single crystal or a polycrystal. Afterwards, the composite crystal layer structure consisting of the single-crystal substrate and the crystal layer is subjected to laser irradiation. The laser can be irradiated from the other surface of the single-crystal substrate, or from the surface of the low-quality crystal layer of the composite crystal layer structure; as long as the focus depth of the laser is managed well, a modified layer can be formed inside the single-crystal substrate of the composite crystal layer structure; subsequently, the single-crystal substrate is divided along the modified layer to obtain a composite substrate having a thin high-quality single-crystal substrate and a low-quality crystal layer with a specific thickness. The preparation method of the present application can improve the manufacturing efficiency and quality of the composite substrate.

The preparation method of the present application involves growing a single layer oflow-quality crystal layer on a high-quality single-crystal substrate without forming a bonding interface layer, and therefore will not adversely affect the vertical conductivity of the high-quality single-crystal substrate.

In an embodiment, the single-crystal substrate in step (1) is a silicon carbide substrate.

In an embodiment, the single-crystal substrate has a thickness of 150-1000 µm, which may be, for example, 150 µm, 200 µm, 400 µm, 700 µm, 900 µm, or 1000 µm, but is not limited to the listed values, and other unlisted values within the numerical range are also applicable.

In an embodiment, the single-crystal substrate has a crystal type comprising 4H or 6H.

In an embodiment, a face of the single-crystal substrate to grow the crystal layer comprises a Si-face or a C-face.

In an embodiment, the single-crystal substrate has a diameter of 2-8 cun, which may be, for example, 2 cun, 3 cun, 4 cun, 5 cun, 6 cun, or 8 cun, but is not limited to the listed values, and other unlisted values within the numerical range are also applicable.

In an embodiment, the {0001} crystal plane of the single-crystal substrate and the surface of the single-crystal substrate in step (1) form an angle of 0°-8°, which may be, for example, 0°, 1°, 1.5°, 2°, 3°, 5°, or 8°, but is not limited to the listed values, and other unlisted values within the numerical range are also applicable.

In the present application, optionally, the {0001} crystal plane of the single-crystal substrate and the surface of the single-crystal substrate in step (1) form an angle of 0°-8°, because using the laser to irradiate the crystal will generate cracks therein. The fracture toughness of the {1100} and {1120} crystal planes of the crystal is about 1.5 times that of the {0001} crystal plane, and therefore, the cracks tend to spread towards the {0001} crystal plane. In other words, the modified layer is approximately parallel to the {0001 } crystal plane.

In a case where the {0001} crystal plane of the single-crystal substrate 1 and the surface of the substrate form an angle θ (i.e., θ off-axis), when the modified layer is ground and polished, adjusting the angle between the reference plane of grinding and polishing and the modified layer to be θ can guarantee the substrate after being ground and polished having θ off-axis, 0°-8°.

In an embodiment, the crystal layer in step (1) comprises a single crystal or a polycrystal.

In an embodiment, the crystal layer in the composite crystal layer structure has a thickness of 100-1000 µm, which may be, for example, 100 µm, 300 µm, 500 µm, 700 µm, 900 µm, or 1000 µm, but is not limited to the listed values, and other unlisted values within the numerical range are also applicable.

In an embodiment, a method for growing the crystal layer in step (1) comprises any one of physical vapor transport, solution growth, or high-temperature chemical vapor deposition.

In an embodiment, a growth rate of the crystal layer is 300-5000 µm/h, which may be, for example, 300 µm/h, 400 µm/h, 500 µm/h, 600 µm/h, 700 µm/h, 800 µm/h, 900 µm/h, 1000 µm/h, 2000 µm/h, 3000 µm/h, 4000 µm/h, 4500 µm/h, or 5000 µm/h, but is not limited to the listed values, and other unlisted values within the numerical range are also applicable.

In general, the growth quality of the crystal layer decreases as the growth rate increases. Therefore, a higher growth rate can be adopted for the growth of low-quality crystal layer, and the crystal is allowed to contain more defects such as micropipes, dislocations, phase transformations, and polycrystal inclusions, and even to transition from single crystal to polycrystal. In the present application, optionally, the growth rate of the crystal layer is 300-5000 µm/h; when the growth rate is low, the preparation time of the composite substrate will be long, and the preparation efficiency will be low; when the growth rate is high, the crystal layer will accordingly have impurities or pores, and the composite substrate obtained will be of poor quality.

In an embodiment, before the laser irradiation in step (2), a surface to be laser-irradiated of the composite crystal layer structure is ground and polished to allow the laser energy to penetrate the surface as much as possible and focus on the modified layer.

In an embodiment, the laser in step (2) is a pulsed laser.

In an embodiment, the pulsed laser comprises a solid-state laser or a fiber laser.

In an embodiment, the pulsed laser has a pulse width of 100-300 fs, which may be, for example, 100 fs, 120 fs, 150 fs, 200 fs, 240 fs, or 300 fs, but is not limited to the listed values, and other unlisted values within the numerical range are also applicable.

In the present application, optionally, the pulsed laser has a pulse width of 100-300 fs; when the pulse width is too small, the single-crystal substrate cannot be well cut off along the modified layer; when the pulse width is too large, there will be cracks on the modified layer, which will seriously affect the quality of the composite substrate.

In an embodiment, a scanning path of the laser irradiation in step (2) comprises any one of parallel straight lines, concentric circles, bent lines, or curves.

In an embodiment, the laser irradiation in step (2) has scanning paths: scanning paths which are parallel to each other are divided into groups from top to bottom, and each group has N scanning paths; in a case where there are M groups in total, first scanning paths of groups 1 to M, second scanning paths of groups 1 to M, third scanning paths of groups 1 to M, and so on are scanned in sequence until all paths are scanned over. Two successive paths can be scanned along the same or opposite direction.

The purpose of optimizing the laser scanning path in the present application is to facilitate the internal stress induced by the laser irradiation in the crystal as evenly distributed as possible, and to prevent or reduce the warping and deformation of the substrate after the division along the modified layer which is caused by excessive stress concentration.

In an embodiment, the modified layer of the composite substrate obtained in step (2) is ground and polished to achieve a desired surface quality.

In an embodiment, a remaining part of the single-crystal substrate after being divided along the modified layer is ground and polished and then reused as a seed crystal.

In an embodiment, after the composite substrate in step (2) is ground and polished, the single-crystal substrate in the composite substrate has a thickness of 1-50 µm, which may be, for example, 1 µm, 5 µm, 10 µm, 20 µm, 30 µm, 40 µm, or 50 µm, but is not limited to the listed values, and other unlisted values within the numerical range are also applicable.

As an optional technical solution of the present application, the preparation method comprises the following steps:
(1) growing a crystal layer on one surface of a single-crystal substrate which is used as a seed crystal to obtain a composite crystal layer structure consisting of the single-crystal substrate and the crystal layer, wherein the crystal layer has a thickness of 100-1000 µm;
   the single-crystal substrate is a silicon carbide substrate with a thickness of 150-1000 µm, and a crystal type comprises 4H or 6H; a face of the single-crystal substrate to grow the crystal layer comprises a Si-face or a C-face; the {0001} crystal plane of the single-crystal substrate and the surface of the single-crystal substrate form an angle of 0°-8°;
   the crystal layer comprises single crystal or a polycrystal; a method for growing the crystal layer comprises any one of physical vapor transport, solution growth, or high-temperature chemical vapor deposition; a growth rate of the crystal layer is 300-5000 µm/h; and
(2) grinding and polishing a surface to be laser-irradiated of the composite crystal layer structure, and then subjecting the composite crystal layer structure to laser irradiation to form a modified layer inside the single-crystal substrate of the composite crystal layer structure; dividing the single-crystal substrate along the modified layer by applying an external force, and grinding and polishing to obtain a composite substrate having a single-crystal substrate of 1-50 µm thickness;
   the laser is a pulsed laser; the pulsed laser comprises a solid-state laser or a fiber laser; the pulsed laser has a pulse width of 100-300 fs;
   a scanning path of the laser irradiation in step (2) comprises any one of parallel straight lines, concentric circles, bent lines, or curves; the laser irradiation has scanning paths: scanning paths which are parallel to each other are divided into groups from top to bottom, and each group has N scanning paths; in a case where there are M groups in total, first scanning paths of groups 1 to M, second scanning paths of groups 1 to M, third scanning paths of groups 1 to M, and so on are scanned in sequence until all paths are scanned over;
   after the composite substrate is ground and polished, the single-crystal substrate in the composite substrate has a thickness of 1-50 µm; the remaining part of the single-crystal substrate after being divided along the modified layer is ground and polished and then reused as a seed crystal.

Compared with the related art, the present application has at least the following beneficial effects:
(1) the preparation method for a composite substrate provided by the present application has a facile process, a single layer of low-quality crystal layer is grown on a high-quality single-crystal substrate, and no bonding interface is formed, which will not adversely affect the vertical conductivity of the high-quality single-crystal substrate; and
(2) in the preparation method for a composite substrate provided by the present application, the high-quality single-crystal substrate is removed by laser cutting, and a composite substrate having a thin high-quality single-crystal substrate can be obtained; the manufacturing efficiency is high and the composite substrate is of high quality.

Other aspects will be appreciated upon reading and understanding the drawings and detailed description.

### BRIEF DESCRIPTION OF DRAWINGS

The drawings are used to provide a further understanding of the technical solutions herein and form part of the specification. The drawings are used in conjunction with the embodiments of the present application to explain the technical solutions herein and do not constitute a limitation to the technical solutions herein.
FIG. 1 is a schematic diagram showing a preparation method for a composite substrate provided in Example 1.
FIG. 2 is a schematic diagram showing a modified surface in Example 1.
FIG. 3 is a schematic diagram showing scanning paths of laser irradiation in Example 1.
FIG. 4 is a schematic diagram showing a device of induction-heating physical vapor transport method for growing crystals in Example 1.
FIG. 5 is a schematic diagram showing a preparation method for a composite substrate provided in Example 2.
FIG. 6 is a schematic diagram showing scanning paths of laser irradiation in Example 2.
FIG. 7 is a schematic diagram showing a device of resistance-heating physical vapor transport method for growing crystals in Example 2.
FIG. 8 is a schematic diagram showing scanning paths of laser irradiation in Example 3.
FIG. 9 is a schematic diagram showing a device of induction-heating solution growth method for growing crystals in Example 3.
FIG. 10 is a schematic diagram showing a device of resistance-heating solution growth method for growing crystals in Example 4.
FIG. 11 is a schematic diagram showing a device of induction-heating high-temperature chemical vapor deposition method for growing crystals in Example 5.
FIG. 12 is a schematic diagram showing a device of resistance-heating high-temperature chemical vapor deposition method for growing crystals in Example 6.

In the figures: 1-single-crystal substrate; 101-single-crystal substrate remaining on the composite substrate; 102-remaining part after division along the modified layer; 2-crystal layer; 20-silicon carbide powder; 21-crucible cover; 3-graphite support; 4-seed crystal rod; 40-laser; 5-graphite crucible; 6-crucible support; 7-heat insulating box; 8-induction heating coil; 9-cavity; 10-reaction chamber; and 11-resistance heater.

### DETAILED DESCRIPTION

The technical solutions of the present application are further described below by the drawings and embodiments.

The present application is described in further detail below. However, the following embodiments are only simple examples of the present application and do not represent or limit the scope of protection provided by the present application, and the scope of protection is defined by the claims.

### Example 1

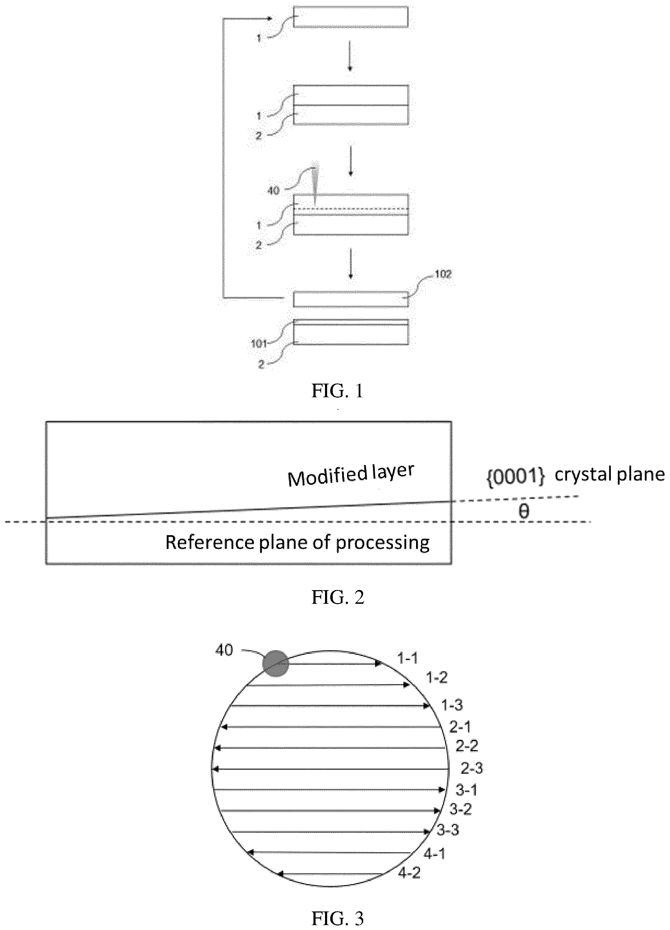

This example provides a preparation method for a composite substrate. FIG. 1 shows the schematic diagram of the preparation method. The preparation method comprises the following steps:
(1) a single-crystal substrate 1 was used as a seed crystal, and a crystal layer 2 was grown on one surface of the single-crystal substrate 1 to obtain a composite crystal layer structure consisting of the single-crystal substrate 1 and the crystal layer 2; the crystal layer 2 had a thickness of 350 µm;
   the single-crystal substrate 1 was a silicon carbide substrate with a thickness of 500 µm and a crystal type of 4H; a face of the single-crystal substrate 1 to grow the crystal layer 2 was a Si-face; and the {0001} crystal plane of the single-crystal substrate 1 and the surface of the single-crystal substrate 1 formed an angle of 4°, i.e., 4° off-axis;
   the crystal layer 2 was a single crystal; a method for growing the crystal layer 2 was physical vapor transport; a growth rate of the crystal layer 2 was 3000 µm/h;
(2) a surface to be laser-irradiated of the composite crystal layer structure was ground and polished, and then the other surface of the single-crystal substrate 1 in the composite crystal layer structure was irradiated with laser 40 to form a modified layer inside the single-crystal substrate 1 of the composite crystal layer structure; FIG. 2 is a schematic diagram showing the modified layer; the single-crystal substrate 1 was divided by an external force along the modified layer, and the modified layer was ground and polished to obtain a composite substrate which had a single-crystal substrate remaining on the composite substrate 101 of 2 µm thickness; when the modified layer was ground and polished, the angle between the reference plane of grinding and polishing and the modified layer was adjusted to 4°, whereby the substrate after being ground and polished still had 4°off-axis;
   the laser 40 was a pulsed laser; the pulsed laser was a solid-state laser; the pulsed laser had a pulse width of 200 fs; the laser irradiation had scanning paths: scanning paths which were parallel to each other were divided into groups from top to bottom, and each group had N scanning paths; in a case where there were M groups in total, first scanning paths of groups 1 to M, second scanning paths of groups 1 to M, third scanning paths of groups 1 to M, and so on were scanned in sequence until all paths were scanned over; specifically, the scanning sequence was as follows: 1-1, 2-1, 3-1, 4-1, 1-2, 2-2, 3-2, 4-2, 1-3, 2-3, 3-3, ...; two successive scanning paths were scanned along an opposite direction, as shown in FIG. 3;
   the remaining part 102 of the single-crystal substrate 1 after being divided along the modified layer was ground and polished and then reused as a seed crystal.

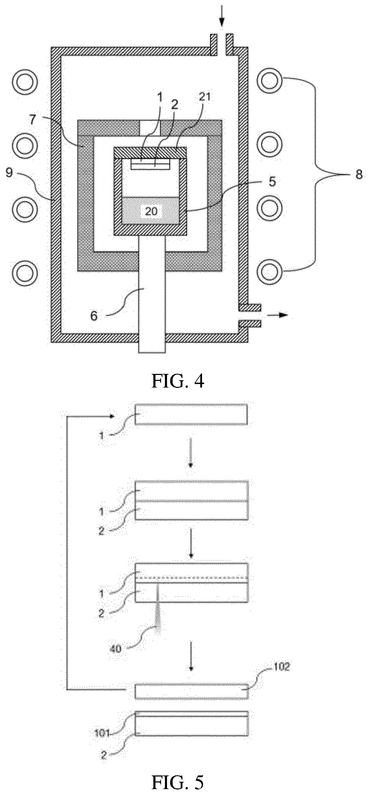

This example is carried out in a device of induction-heating physical vapor transport method for growing crystals; FIG. 4 shows a schematic structural diagram of the device; the device comprises a graphite crucible 5, a single-crystal substrate 1, a crucible cover 21, a crucible support 6, a heat insulating box 7, an induction heating coil 8, and a cavity 9; the cavity 9 has at least one gas outlet and at least one gas inlet. The graphite crucible 5 is filled with silicon carbide powder 20.

The crucible cover 21 is connected to the single-crystal substrate 1, and one surface of the single-crystal substrate 1 faces the silicon carbide powder 20. The crucible support 6 supports the graphite crucible 5 and drives the graphite crucible 5 to rotate, or move in a vertical direction. The graphite crucible 5 is surrounded by the heat insulating box 7 on the outer side, the heat insulating box 7 is arranged inside the chamber 9, and the chamber 9 is peripherally provided with the induction heating coil 8. The induction heating coil 8 is helical, and the current frequency is 8 kHz, and the coil is hollow, and can be cooled by introducing water. The energized induction heating coil 8 heats the silicon carbide powder 20 in the crucible, and sublimes the silicon carbide powder 20. The crucible support 6 passes through the wall of the cavity 9.

### Example 2

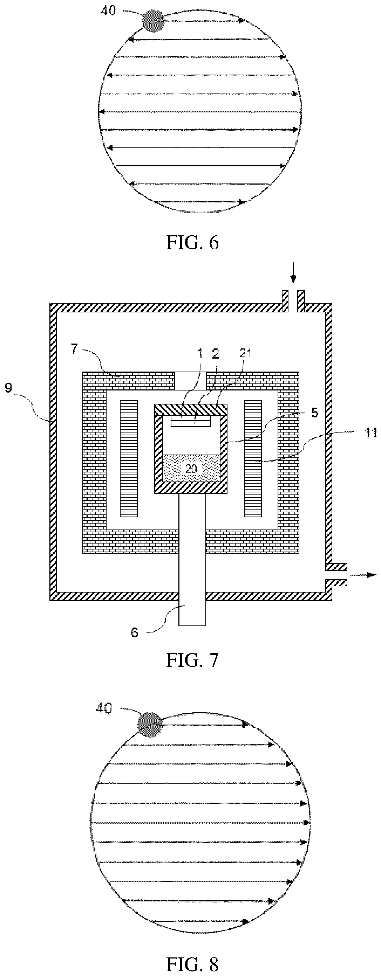

This example provides a preparation method for a composite substrate. FIG. 5 shows the schematic diagram of the preparation method. The preparation method comprises the following steps:
(1) a single-crystal substrate 1 was used as a seed crystal, and a crystal layer 2 was grown on one surface of the single-crystal substrate 1 to obtain a composite crystal layer structure consisting of the single-crystal substrate 1 and the crystal layer 2; the crystal layer 2 had a thickness of 200 µm;
   the single-crystal substrate 1 was a silicon carbide substrate with a thickness of 200 µm and a crystal type of 6H; a face of the single-crystal substrate 1 to grow the crystal layer 2 was a C-face; and the {0001} crystal plane of the single-crystal substrate 1 and the surface of the single-crystal substrate 1 formed an angle of 8°, i.e., 8° off-axis;
   the crystal layer 2 was a polycrystal; a method for growing the crystal layer 2 was physical vapor transport; a growth rate of the crystal layer 2 was 300 µm/h;
(2) a surface to be laser-irradiated of the composite crystal layer structure was ground and polished, and then the surface of the crystal layer 2 in the the composite crystal layer structure was irradiated with laser 40 to form a modified layer inside the single-crystal substrate 1 of the composite crystal layer structure; the single-crystal substrate 1 was divided by an external force along the modified layer, and the modified layer was ground and polished to obtain a composite substrate which had a single-crystal substrate remaining on the composite substrate 101 of 10 µm thickness; when the modified layer was ground and polished, the angle between the reference plane of grinding and polishing and the modified layer was adjusted to 8°, whereby the substrate after being ground and polished still had 8°off-axis;
   the laser 40 was a pulsed laser; the pulsed laser was a fiber laser; the pulsed laser had a pulse width of 100 fs; scanning paths of the laser irradiation were a series of straight lines parallel to each other, and the space between two adjacent paths was consistent; each scanning path had an opposite scanning direction, and the scanning was carried out from top to bottom on each path in sequence, as shown in FIG. 6;
   the remaining part 102 of the single-crystal substrate 1 after being divided along the modified layer was ground and polished and then reused as a seed crystal.

This example is carried out in a device of resistance-heating physical vapor transport method for growing crystals; FIG. 7 shows a schematic structural diagram of the device; the device comprises a graphite crucible 5, a single-crystal substrate 1, a crucible cover 21, a crucible support 6, a heat insulating box 7, a resistance heater 11, and a cavity 9; the cavity 9 has at least one gas outlet and at least one gas inlet. The graphite crucible 5 is filled with silicon carbide powder 20.

The crucible cover 21 is connected to the single-crystal substrate 1, and one surface of the single-crystal substrate 1 faces the silicon carbide powder 20. The crucible support 6 supports the graphite crucible 5 and drives the graphite crucible 5 to rotate, or move in a vertical direction. The graphite crucible 5 is surrounded by the resistance heater 11 on the outer side, and enclosed by the heat insulating box 7. The resistance heater 11 is a graphite heater, and the energized graphite heater heats the silicon carbide powder 20 in the graphite crucible 5, and sublimes the silicon carbide powder 20. The crucible support 6 passes through the wall of the cavity 9.

### Example 3

This example provides a preparation method for a composite substrate. The preparation method comprises the following steps:
(1) a single-crystal substrate 1 was used as a seed crystal, and a crystal layer 2 was grown on one surface of the single-crystal substrate 1 to obtain a composite crystal layer structure consisting of the single-crystal substrate 1 and the crystal layer 2; the crystal layer 2 had a thickness of 100 µm;
   the single-crystal substrate 1 was a silicon carbide substrate with a thickness of 1000 µm and a crystal type of 4H; a face of the single-crystal substrate 1 to grow the crystal layer 2 was a C-face; and the {0001} crystal plane of the single-crystal substrate 1 and the surface of the single-crystal substrate 1 formed an angle of 0°, i.e., 0° off-axis;
   the crystal layer 2 was a polycrystal; a method for growing the crystal layer 2 was solution growth; a growth rate of the crystal layer 2 was 5000 µm/h;
(2) a surface to be laser-irradiated of the composite crystal layer structure was ground and polished, and then the composite crystal layer structure was irradiated with laser to form a modified layer inside the single-crystal substrate 1 of the composite crystal layer structure; the single-crystal substrate 1 was divided by an external force along the modified layer, and the modified layer was ground and polished to obtain a composite substrate which had a single-crystal substrate remaining on the composite substrate 101 of 46 µm thickness; when the modified layer was ground and polished, the angle between the reference plane of grinding and polishing and the modified layer was adjusted to 0°, whereby the substrate after being ground and polished still had 0°off-axis;
   the laser was a pulsed laser; the pulsed laser was a solid-state laser; the pulsed laser had a pulse width of 300 fs; scanning paths of the laser irradiation were a series of straight lines parallel to each other, and the space between two adjacent paths was consistent; each scanning path had a same scanning direction, and the scanning was carried out from top to bottom on each path in sequence, as shown in FIG. 8;
   the remaining part 102 of the single-crystal substrate 1 after being divided along the modified layer was ground and polished and then reused as a seed crystal.

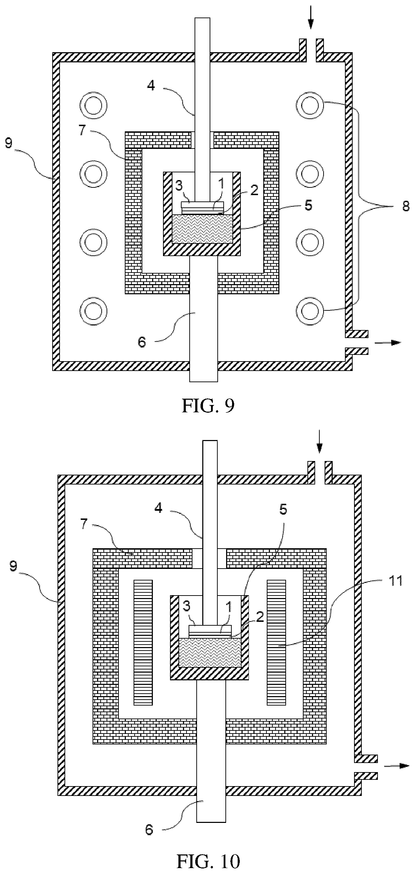

This example is carried out in a device of induction-heating solution growth method for growing crystals; FIG. 9 shows a schematic structural diagram of the device; the device comprises a graphite crucible 5, a seed crystal rod 4, a graphite support 3, a single-crystal substrate 1, a crucible support 6, a heat insulating box 7, an induction heating coil 8, and a cavity 9. The cavity 9 has at least one gas outlet and at least one gas inlet. The graphite crucible 5 is filled with a fluxing agent solution.

The seed crystal rod 4 is connected to the graphite support 3, the bottom of the graphite support 3 can be connected to a composite seed crystal, and the seed crystal rod 4 can rotate, and move in a vertical direction. The crucible support 6 supports the graphite crucible 5 and drives the graphite crucible 5 to rotate, and move in a vertical direction. The graphite crucible 5 is enclosed by the heat insulating box 7 on the outer side, and the heat insulating box 7 is peripherally provided with the induction heating coil 8. The induction heating coil 8 is helical, and the current frequency is 3 kHz, and the coil is hollow, and can be cooled by introducing water. The energized induction heating coil 8 heats the fluxing agent in the graphite crucible 5 to melt. The cavity 9 provides an atmosphere environment for crystal growth. The seed crystal rod 4 and crucible support 6 pass through the wall of the cavity 9.

### Example 4

This example provides a preparation method for a composite substrate. The preparation method comprises the following steps:
(1) a single-crystal substrate 1 was used as a seed crystal, and a crystal layer 2 was grown on one surface of the single-crystal substrate 1 to obtain a composite crystal layer structure consisting of the single-crystal substrate 1 and the crystal layer 2; the crystal layer 2 had a thickness of 100 µm;
   the single-crystal substrate 1 was a silicon carbide substrate with a thickness of 150 µm and a crystal type of 4H; a face of the single-crystal substrate 1 to grow the crystal layer 2 was a Si-face; and the {0001} crystal plane of the single-crystal substrate 1 and the surface of the single-crystal substrate 1 formed an angle of 3°, i.e., 3° off-axis;
   the crystal layer 2 was a single crystal; a method for growing the crystal layer 2 was solution growth; a growth rate of the crystal layer 2 was 2400 µm/h;
(2) a surface to be laser-irradiated of the composite crystal layer structure was ground and polished, and then the composite crystal layer structure was irradiated with laser to form a modified layer inside the single-crystal substrate 1 of the composite crystal layer structure; the single-crystal substrate 1 was divided by an external force along the modified layer, and the modified layer was ground and polished to obtain a composite substrate which had a single-crystal substrate remaining on the composite substrate 101 of 1 µm thickness; when the modified layer was ground and polished, the angle between the reference plane of grinding and polishing and the modified layer was adjusted to 3°, whereby the substrate after being ground and polished still had 3°off-axis;
   the laser was a pulsed laser; the pulsed laser was a fiber laser; the pulsed laser had a pulse width of 160 fs; scanning paths of the laser irradiation were a series of straight lines parallel to each other, and the space between two adjacent paths was consistent; each scanning path had a same scanning direction, and the scanning was carried out from top to bottom on each path in sequence;
   the remaining part 102 of the single-crystal substrate 1 after being divided along the modified layer was ground and polished and then reused as a seed crystal.

This example is carried out in a device of resistance-heating solution growth method for growing crystals; FIG. 10 shows a schematic structural diagram of the device; the device comprises a graphite crucible 5, a seed crystal rod 4, a graphite support 3, a single-crystal substrate 1, a crucible support 6, a heat insulating box 7, a resistance heater 11, and a cavity 9. The cavity 9 has at least one gas outlet and at least one gas inlet. The graphite crucible 5 is filled with a fluxing agent solution.

The seed crystal rod 4 is connected to the graphite support 3, the bottom of the graphite support 3 can be connected to a composite seed crystal, and the seed crystal rod 4 can rotate, and move in a vertical direction. The crucible support 6 supports the graphite crucible 5 and drives the graphite crucible 5 to rotate, and move in a vertical direction. The graphite crucible 5 is surround by the resistance heater 11 on the outer side, and enclosed by the heat insulating box 7. The resistance heater 11 is a graphite heater, and the energized graphite heater heats the fluxing agent in the graphite crucible 5 to melt. The cavity 9 provides an atmosphere environment for crystal growth. The seed crystal rod 4 and crucible support 6 pass through the wall of the cavity 9.

### Example 5

This example provides a preparation method for a composite substrate. The preparation method comprises the following steps:
(1) a single-crystal substrate 1 was used as a seed crystal, and a crystal layer 2 was grown on one surface of the single-crystal substrate 1 to obtain a composite crystal layer structure consisting of the single-crystal substrate 1 and the crystal layer 2; the crystal layer 2 had a thickness of 750 µm;
   the single-crystal substrate 1 was a silicon carbide substrate with a thickness of 630 µm and a crystal type of 6H; a face of the single-crystal substrate 1 to grow the crystal layer 2 was a Si-face; and the {0001} crystal plane of the single-crystal substrate 1 and the surface of the single-crystal substrate 1 formed an angle of 5°, i.e., 5° off-axis;
   the crystal layer 2 was a polycrystal; a method for growing the crystal layer 2 was high-temperature chemical vapor deposition; a growth rate of the crystal layer 2 was 500 µm/h;
(2) a surface to be laser-irradiated of the composite crystal layer structure was ground and polished, and then the composite crystal layer structure was irradiated with laser to form a modified layer inside the single-crystal substrate 1 of the composite crystal layer structure; the single-crystal substrate 1 was divided by an external force along the modified layer, and the modified layer was ground and polished to obtain a composite substrate which had a single-crystal substrate remaining on the composite substrate 101 of 24 µm thickness; when the modified layer was ground and polished, the angle between the reference plane of grinding and polishing and the modified layer was adjusted to 5°, whereby the substrate after being ground and polished still had 5°off-axis;
   the laser was a pulsed laser; the pulsed laser was a solid-state laser; the pulsed laser had a pulse width of 160 fs; scanning paths of the laser irradiation were a series of straight lines parallel to each other, and the space between two adjacent paths was consistent; each scanning path had an opposite scanning direction, and the scanning was carried out from top to bottom on each path in sequence;
   the remaining part 102 of the single-crystal substrate 1 after being divided along the modified layer was ground and polished and then reused as a seed crystal.

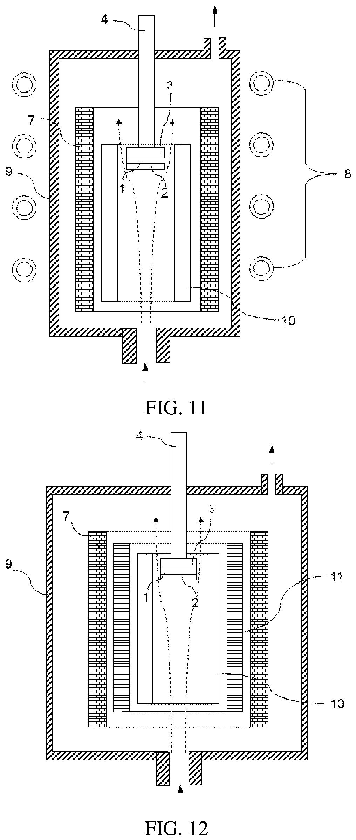

This example is carried out in a device of induction-heating high-temperature chemical vapor deposition method for growing crystals; FIG. 11 shows a schematic structural diagram of the device; the device comprises a seed crystal rod 4, a graphite support 3, a single-crystal substrate 1, a reaction chamber 10, a heat insulating box 7, an induction heating coil 8, and a cavity 9. The cavity 9 has at least one gas outlet and at least one gas inlet.

The seed crystal rod 4 is connected to the graphite support 3, the bottom of the graphite support 3 can be connected to a composite seed crystal, and the seed crystal rod 4 can rotate, and move in a vertical direction. The reaction chamber 10 is made of graphite and enclosed by the heat insulating box 7 on the outer side, the heat insulating box 7 is arranged inside the cavity 9, and the cavity 9 is peripherally provided with the induction heating coil 8. The induction heating coil 8 is helical, and the current frequency is 20 kHz, and the coil is hollow, and can be cooled by introducing water. The seed crystal rod 4 passes through the wall of the cavity 9. The energized induction heating coil 8 heats the reaction chamber 10 to a temperature of crystal growth.

The cavity 9 is filled with a reactive gas from the gas inlet, the reactive gas comprises a silicon source gas and a carbon source gas, and the silicon source gas is silane and the carbon source gas is propane.

### Example 6

This example provides a preparation method for a composite substrate. The preparation method comprises the following steps:
(1) a single-crystal substrate 1 was used as a seed crystal, and a crystal layer 2 was grown on one surface of the single-crystal substrate 1 to obtain a composite crystal layer structure consisting of the single-crystal substrate 1 and the crystal layer 2; the crystal layer 2 had a thickness of 330 µm;
   the single-crystal substrate 1 was a silicon carbide substrate with a thickness of 670 µm and a crystal type of 4H; a face of the single-crystal substrate 1 to grow the crystal layer 2 was a Si-face; and the {0001} crystal plane of the single-crystal substrate 1 and the surface of the single-crystal substrate 1 formed an angle of 7°, i.e., 7° off-axis;
   the crystal layer 2 was a single crystal; a method for growing the crystal layer 2 was high-temperature chemical vapor deposition; a growth rate of the crystal layer 2 was 800 µm/h;
(2) a surface to be laser-irradiated of the composite crystal layer structure was ground and polished, and then the composite crystal layer structure was irradiated with laser to form a modified layer inside the single-crystal substrate 1 of the composite crystal layer structure; the single-crystal substrate 1 was divided by an external force along the modified layer, and the modified layer was ground and polished to obtain a composite substrate which had a single-crystal substrate remaining on the composite substrate 101 of 41 µm thickness; when the modified layer was ground and polished, the angle between the reference plane of grinding and polishing and the modified layer was adjusted to 7°, whereby the substrate after being ground and polished still had 7°off-axis;
   the laser was a pulsed laser; the pulsed laser was a solid-state laser; the pulsed laser had a pulse width of 140 fs; the laser irradiation had scanning paths: scanning paths which were parallel to each other were divided into groups from top to bottom, and each group had N scanning paths; in a case where there were M groups in total, first scanning paths of groups 1 to M, second scanning paths of groups 1 to M, third scanning paths of groups 1 to M, and so on were scanned in sequence until all paths were scanned over; specifically, the scanning sequence was as follows: 1-1, 2-1, 3-1, 4-1, 1-2, 2-2, 3-2, 4-2, 1-3, 2-3, 3-3, ...; two successive scanning paths were scanned along an opposite direction;
   the remaining part 102 of the single-crystal substrate 1 after being divided along the modified layer was ground and polished and then reused as a seed crystal.

This example is carried out in a device of resistance-heating high-temperature chemical vapor deposition method for growing crystals; FIG. 12 shows a schematic structural diagram of the device; the device comprises a seed crystal rod 4, a graphite support 3, a single-crystal substrate 1, a reaction chamber 10, a heat insulating box 7, a resistance heater 11, and a cavity 9. The cavity 9 has at least one gas outlet and at least one gas inlet.

The seed crystal rod 4 is connected to the graphite support 3, the bottom of the graphite support 3 can be connected to a composite seed crystal, and the seed crystal rod 4 can rotate, and move in a vertical direction. The reaction chamber 10 is made of graphite and peripherally provided with the resistance heater 11, the resistance heater 11 is arranged inside the heat insulating box 7, and the heat insulating box 7 is arranged inside the cavity 9. The seed crystal rod 4 passes through the wall of the cavity 9. The resistance heater 11 is a graphite heater, and the energized graphite heater heats the reaction chamber 10 to a temperature of crystal growth.

The cavity 9 is filled with a reactive gas from the gas inlet, the reactive gas comprises a silicon source gas and a carbon source gas, and the silicon source gas is silane and the carbon source gas is propane.

### Example 7

This example provides a preparation method for a composite substrate, and except that the growth rate of the crystal layer is 150 µm/h instead of 3000 µm/h, the preparation method is the same as that of Example 1.

### Example 8

This example provides a preparation method for a composite substrate, and except that the growth rate of the crystal layer is 5500 µm/h instead of 3000 µm/h, the preparation method is the same as that of Example 1.

### Example 9

This example provides a preparation method for a composite substrate, and except that the pulse width of the pulsed laser is 50 fs instead of 200 fs, the preparation method is the same as that of Example 1.

In this example, because the pulse width of the pulsed laser is only 50 fs, the single-crystal substrate cannot be divided along the modified layer, and the composite substrate cannot be obtained.

### Example 10

This example provides a preparation method for a composite substrate, and except that the pulse width of the pulsed laser is 350 fs instead of 200 fs, the preparation method is the same as that of Example 1.

### Example 11

This example provides a preparation method for a composite substrate, and except that the scanning paths of the laser irradiation are a series of straight lines parallel to each other, and the ispace between two adjacent paths was consistent; each scanning path has the same scanning direction, the preparation method is the same as that of Example 1.

### Comparative Example 1

This comparative example provides a preparation method for a composite substrate, comprising the following steps:
a single-crystal substrate and a crystal layer were prepared separately by physical vapor transport method and both had a crystal type of 4H and a thickness of 350 µm; the {0001} crystal plane of the single-crystal substrate and the surface of the single-crystal substrate formed an angle of 4°;
one surface of the single-crystal substrate was subjected to ion implantation or laser irradiation, and a pre-buried weakened layer was formed at a depth of 2 µm from this surface;
the ion-implanted surface or laser-irradiated surface of the single-crystal substrate was bonded to one surface of the crystal layer, so as to obtain a composite substrate comprising the single-crystal substrate, the crystal layer, and a bonding interface layer between the two layers;
the composite substrate was heat-treated so that the single-crystal substrate was divided along the pre-buried weakened layer, and a thickness of the single-crystal substrate in the composite substrate obtained was 2 µm.

The resistance value of the composite substrate obtained from the above examples and comparative examples is measured by the following method: a back electrode is formed on a surface of the crystal layer of the composite silicon carbide substrate, and a circular surface electrode with a diameter of 0.3 mm is formed on a surface of the single-crystal substrate; a voltage V is applied between the surface electrode and the back electrode, and the corresponding current I is recorded to obtain the V-I curve and calculate the resistance value.
(1) It can be seen by analyzing Example 1 and Comparative Example 1 that the resistance value of Example 1 is 3.7 Ω, and the resistance value of Comparative Example 1 is higher and reaches 4.0 Ω because the bonding interface layer adversely affects the vertical conductivity of the composite substrate in Comparative Example 1. The preparation method for a composite substrate provided by the present application can produce a composite substrate with high quality and better vertical conductivity.
(2) It can be seen by analyzing Example 1 and Examples 7-8 that due to the growth rate of the crystal layer is only 150 µm/h in Example 7, the prepared composite substrate is of high quality and has a resistance value of 3.6 Ω; however, it takes a long period to prepare the composite substrate, and the efficiency of the preparation is low; in Example 8, due to the growth rate of the crystal layer is too high, there will be impurities, or pores, etc. in the crystal layer, and the prepared composite substrate is of poor quality and has a resistance value of 3.9 Ω.
(3) It can be seen by analyzing Example 1 and Examples 9-10 that due to the pulse width of the pulsed laser is only 50 fs in Example 9, the single-crystal substrate cannot be divided along the modified layer, and thus the composite substrate cannot be obtained; due to the pulse width of the pulsed laser is 350 fs in Example 10, cracks are generated on the modified layer, which seriously affect the quality of the composite substrate.
(4) It can be seen by analyzing Example 1 and Example 11 that scanning paths of the laser irradiation in Example 1 are as follows: scanning paths which are parallel to each other were divided into groups from top to bottom, and each group had N scanning paths; in a case where there were M groups in total, first scanning paths of groups 1 to M, second scanning paths of groups 1 to M, third scanning paths of groups 1 to M, and so on were scanned in sequence until all paths were scanned over; specifically, the scanning sequence is as follows: 1-1, 2-1, 3-1, 4-1, 1-2, 2-2, 3-2, 4-2, 1-3, 2-3, 3-3, ...; two successive scanning paths were scanned along an opposite direction; the sliced modified layer which is formed inside the single-crystal substrate of the composite crystal layer structure does not have warpage deformation or the degree of deformation is very small, and the degree of warpage WARP is only 16 µm; the scanning paths of the laser irradiation in Example 11 are a series of straight lines parallel to each other, and the space between two adjacent paths is consistent; each scanning path has the same scanning direction; the sliced modified layer which is formed inside the single-crystal substrate of the composite crystal layer structure has warpage deformation, and the degree of warpage WARP is 29 µm. In summary, the preparation method for a composite substrate provided by the present application has a facile process, and the preparation method involves growing a single layer of low-quality crystal layer on a high-quality single-crystal substrate without forming a bonding interface; subsequently, the high-quality single-crystal substrate is removed by laser cutting to obtain a composite substrate having a thin high-quality single-crystal substrate, the preparation efficiency is high and the quality of the composite substrate is high.

The applicant declares that although the embodiments of the present application are described above, but the scope of protection of the present application is not limited thereto. It should be apparent to those skilled in the art that any changes or substitutions which are obvious to those skilled in the art within the technical scope disclosed by the present application shall fall within the protection scope and disclosure scope of the present application.

## Claims

1. A preparation method for a composite substrate, comprising the following steps:
(1) growing a crystal layer on one surface of a single-crystal substrate which is used as a seed crystal to obtain a composite crystal layer structure consisting of the single-crystal substrate and the crystal layer; and
(2) subjecting the composite crystal layer structure to laser irradiation to form a modified layer inside the single-crystal substrate of the composite crystal layer structure; dividing the single-crystal substrate along the modified layer by applying an external force to obtain a composite substrate.

2. The preparation method according to claim 1, wherein the single-crystal substrate in step (1) is a silicon carbide substrate;
the single-crystal substrate has a thickness of 150-1000 µm;
the single-crystal substrate has a crystal type comprising 4H or 6H; and
a face of the single-crystal substrate to grow the crystal layer comprises a Si-face or a C-face.

3. The preparation method according to claim 1, wherein the {0001} crystal plane of the single-crystal substrate and the surface of the single-crystal substrate in step (1) form an angle of 0°-8°.

4. The preparation method according to claim 1, wherein the crystal layer in step (1) comprises a single crystal or a polycrystal; and
the crystal layer in the composite crystal layer structure has a thickness of 100-1000 µm.

5. The preparation method according to claim 1, wherein a method for growing the crystal layer in step (1) comprises any one of physical vapor transport, solution growth, or high-temperature chemical vapor deposition; and
a growth rate of the crystal layer is 300-5000 µm/h.

6. The preparation method according to claim 1, wherein before the laser irradiation in step (2), a surface to be laser-irradiated of the composite crystal layer structure is ground and polished.

7. The preparation method according to claim 1, wherein the laser in step (2) is a pulsed laser; the pulsed laser comprises a solid-state laser or a fiber laser; and
the pulsed laser has a pulse width of 100-300 fs.

8. The preparation method according to claim 1, wherein a scanning path of the laser irradiation in step (2) comprises any one of parallel straight lines, concentric circles, bent lines, or curves;
the laser irradiation has scanning paths: scanning paths which are parallel to each other are divided into groups from top to bottom, and each group has N scanning paths; in a case where there are M groups in total, first scanning paths of groups 1 to M, second scanning paths of groups 1 to M, third scanning paths of groups 1 to M, and so on are scanned in sequence until all paths are scanned over.

9. The preparation method according to claim 1, wherein after the composite substrate in step (2) is ground and polished, the single-crystal substrate in the composite substrate has a thickness of 1-50 µm; and
a remaining part of the single-crystal substrate after being divided along the modified layer is ground and polished and then reused as a seed crystal.

10. The preparation method according to any one of claims 1 to 9, wherein the preparation method comprises the following steps:
(1) growing a crystal layer on one surface of a single-crystal substrate which is used as a seed crystal to obtain a composite crystal layer structure consisting of the single-crystal substrate and the crystal layer, wherein the crystal layer has a thickness of 100-1000 µm;
the single-crystal substrate is a silicon carbide substrate with a thickness of 150-1000 µm, and a crystal type comprises 4H or 6H; a face of the single-crystal substrate to grow the crystal layer comprises a Si-face or a C-face; the {0001} crystal plane of the single-crystal substrate and the surface of the single-crystal substrate form an angle of 0°-8°;
the crystal layer comprises a single crystal or a polycrystal; a method for growing the crystal layer comprises any one of physical vapor transport, solution growth, or high-temperature chemical vapor deposition; a growth rate of the crystal layer is 300-5000 µm/h; and
(2) grinding and polishing a surface to be laser-irradiated of the composite crystal layer structure, and then subjecting the composite crystal layer structure to laser irradiation to form a modified layer inside the single-crystal substrate of the composite crystal layer structure; dividing the single-crystal substrate along the modified layer by applying an external force to obtain a composite substrate;
the laser is a pulsed laser; the pulsed laser comprises a solid-state laser or a fiber laser; the pulsed laser has a pulse width of 100-300 fs;
a scanning path of the laser irradiation in step (2) comprises any one of parallel straight lines, concentric circles, bent lines, or curves; the laser irradiation has scanning paths: scanning paths which are parallel to each other are divided into groups from top to bottom, and each group has N scanning paths; in a case where there are M groups in total, first scanning paths of groups 1 to M, second scanning paths of groups 1 to M, third scanning paths of groups 1 to M, and so on are scanned in sequence until all paths are scanned over; and
after the composite substrate is ground and polished, the single-crystal substrate in the composite substrate has a thickness of 1-50 µm; a remaining part of the single-crystal substrate after being divided along the modified layer is ground and polished and then reused as a seed crystal.
